# EUROPEAN PATENT SPECIFICATION

(11) **EP 3 236 275 B1**
(45) Date of publication and mention of the grant of the patent: **17.11.2021**
(21) Application number: 16165707.7
(22) Date of filing: 18.04.2016
(51) Int. Cl.: G01R 31/34

(54) **ELECTRICAL MACHINE COMPRISING A ROTOR MEASUREMENT UNIT FOR MEASURING A ROTOR PARAMETER OF THE ELECTRICAL MACHINE**
ELEKTRISCHE MASCHINE MIT EINER ROTORMESSEINHEIT ZUR MESSUNG EINES ROTORPARAMETERS DER ELEKTRISCHEN MASCHINE
MACHINE ÉLECTRIQUE COMPRENANT UNE UNITÉ DE MESURE DE ROTOR DESTINÉE À MESURER UN PARAMÈTRE DE ROTOR DE LA MACHINE ÉLECTRIQUE

(43) Date of publication of application: 25.10.2017
(73) Proprietor: ABB Schweiz AG, 5400 Baden (CH)
(72) Inventor: RODRIGUEZ, Pedro, 722 25 Västerås (SE); KÄRKKÄINEN, Ilari, 00740 Helsinki (FI); KIVIOJA, Matti, 00620 Helsinki (FI); HOLLA, Janne, 00440 Helsinki (FI); RAUHALA, Tapio, 02630 Espoo (FI)
(74) Representative: Kransell & Wennborg KB

(56) References cited:
- EP-A1- 2 743 669
- EP-A1- 2 995 967
- EP-A2- 2 905 630
- WO-A1-2011/109489
- DE-A1-102009 025 858
- US-B1- 6 693 778

## Description

### TECHNICAL FIELD

The present disclosure generally relates to electrical machines. In particular, it relates to fault condition diagnostics of an electrical machine.

### BACKGROUND

Often found in critical, high power applications, synchronous machines (SM) require reliable condition monitoring systems. Synchronous motors represent large investments and typically drive processes where downtime results in significant capital losses. Thus, detecting faults at an early stage can help to avoid catastrophic failures and is beneficial in the scheduling of maintenance actions. For a long time condition monitoring systems based on monitoring temperature, stator current and vibration have been used. However, practice has shown that detecting failures in synchronous machines is not an easy task and signatures of the failure conditions are difficult to detect by monitoring the above mentioned parameters. It has moreover been problematic to install measurement equipment on the rotor due to complications of how to power the measurement equipment.

Accumetrics Inc. has developed an induction powered telemetry system for detecting rotor earth/ground faults and rotor temperature monitoring. This system, which is based on digital telemetry, is mounted onto the rotor. An induction loop is utilised to power the rotor measurement unit. The main drawback of this technology is the installation procedure which involves placing a power loop around the shaft.

In addition to the complicated installation procedure Accumetrics Inc. provides a solution for rotor measurements, some of the most important failures to be detected such as inter-turn short circuits in the stator or field winding are not detectable with the existing techniques at the very early stage.

The embodiment in Fig. 9 in EP 2 905 630 A2 discloses an apparatus comprising three voltage sensors used to measure the respective voltages of each exciter armature. There are also two self-powered current sensors used to measure the line currents of two of three exciter armatures. The apparatus includes a computational unit for determining whether or not a rectifier circuit connected to the exciter armatures suffers from faults. The computational unit is powered with DC voltage from the main field winding, and there is a DC-DC converter connected between the main field winding and the computational unit.

WO 2011/109489 A1 discloses method and apparatus for fault detection of series diodes in rectifiers in synchronous machines. The voltages across one or both of the individual diodes, and/or the voltage across the pair of diodes are measured to determine a ratio between two of those voltages. The ratio is then analysed to determine if a fault e.g., a short circuit or an open circuit is present. The apparatus includes a telemetry transmitter module connected to diode fault detection modules and configured to transmit data to a telemetry receiver module. The telemetry transmitter module is mounted to the exciter rotor and is powered inductively through closely coupled antenna coils, one rotating and the other non-rotating. These coils provide RF power that is generated in the telemetry receiver unit, coupled to the rotor where it is rectified and regulated by a DC power supply circuit in the telemetry transmitter module.

### SUMMARY

An object of the present disclosure is to provide an electrical machine having an AC/AC exciter and comprising a rotor measurement unit which solve or at least mitigate the problems with the prior art.

The present inventors have realised a much simpler manner of powering measurement equipment installed on a rotor of an electrical machine having an AC/AC exciter, based on the inherent induction present in such electrical machines due to the electromagnetic interaction between the exciter stator winding and the exciter rotor winding which act as primary and secondary windings of a transformer.

The scope of the present invention is defined in appended claim 1.

There is hence according to a first aspect of the present disclosure provided an electrical machine comprising: an exciter stator, a stator, a rotor assembly comprising a main machine rotor having a field winding, and an exciter rotor having an exciter rotor winding, the exciter stator and the exciter rotor (13c) forming part of an AC/AC exciter, a multi-phase exciter rectifier arranged on the rotor assembly, and configured to rectify an AC current from the exciter rotor winding to feed the field winding with a DC current, wherein the multi-phase exciter rectifier has a plurality of phase legs, each phase leg being connected to a respective electrical phase of the exciter rotor winding, and a rotor measurement unit mounted onto the rotor assembly for measuring a rotor parameter, the rotor measurement unit comprising: a measurement system configured to measure the rotor parameter, electronic circuitry configured to receive a rotor parameter measurement from the measurement system, and a first and a second power supply terminal connected to respective electrical phases of the exciter rotor winding or to the field winding to enable powering of the electronic circuitry during standstill operation of the electrical machine.

An electrical machine having an AC/AC exciter is controlled by means of power converters. In particular, the exciter stator is fed with AC power with a controllable frequency. The phases of the exciter rotor winding are connected by means of a transformer configuration. Due to electromagnetic interaction with the exciter stator winding, current is induced in the exciter rotor winding which acts as the secondary winding of a transformer. It has been realised by the inventors that since the stator current fed by the power converter is alternating, current is induced in the exciter rotor winding and the field winding also when the rotor is set in standstill operation, e.g. when rotation of the rotor is locked or when no power is provided to the main machine. This allows powering of the rotor measurement unit also during standstill operation as long as a power converter feeds the exciter stator winding with AC power. It is thereby possible to measure certain rotor parameters such as rotor temperature before for example restarting the electrical machine.

By connecting the first and the second power supply terminal to the AC side of the multi-phase exciter rectifier, i.e. the exciter rotor winding, a higher supply voltage to the rotor measurement unit may be obtained than if the power supply terminals are connected to the DC side of the multi-phase exciter rectifier, because the line-to-line voltage on the AC side is greater than the pole-to-ground voltage on the DC side of the multi-phase exciter rectifier.

According to one embodiment the rotor parameter is an electrical exciter parameter.

According to one embodiment the measurement system comprises a first measurement terminal configured to be connected to an AC side of a multi-phase exciter rectifier of the electrical machine.

According to one embodiment the measurement system comprises a temperature sensor configured to measure a rotor temperature.

According to one embodiment the electronic circuitry comprises a transmitter configured to wirelessly transmit data relating to the rotor parameter measurement to a base station.

According to one embodiment the electronic circuitry is configured to frequency transform the rotor parameter measurement to obtain a frequency spectrum of the rotor parameter measurement.

According to one embodiment the electronic circuitry is configured to compare the frequency spectrum with reference frequency spectra of the rotor parameter to determine whether a fault condition is present.

According to one embodiment the transmitter is configured to wirelessly transmit data concerning a presence of a fault condition.

One embodiment comprises a rectifier configured to rectify current obtained from the first and the second power supply terminals for powering the electronic circuitry with DC current.

One embodiment comprises a base station, wherein the rotor measurement unit is configured to wirelessly transmit data relating to the rotor parameter measurement to the base station, and wherein the base station is configured to process the data relating to the rotor parameter measurement.

According to one embodiment the exciter field winding is connected in a delta connection or a wye connection.

One embodiment comprises a power converter configured to feed the exciter stator with an AC current.

Hereto, according to a second aspect of the present disclosure there is provided a rotor measurement unit configured to be mounted onto a rotor assembly of an electrical machine having an AC/AC exciter, for measuring a rotor parameter, the rotor measurement unit comprising: a measurement system configured to measure the rotor parameter, electronic circuitry configured to receive a rotor parameter measurement from the measurement system, and a first and a second power supply terminal configured to be connected to a winding of the rotor assembly to enable powering of the electronic circuitry during standstill operation of the electrical machine.

According to one embodiment the winding is an exciter rotor winding or a field winding.

According to one embodiment the rotor parameter is an electrical exciter parameter.

According to one embodiment the measurement system comprises a first measurement terminal configured to be connected to an AC side of the multi-phase exciter rectifier.

According to one embodiment the measurement system comprises a temperature sensor configured to measure a rotor temperature.

According to one embodiment the electronic circuitry comprises a transmitter configured to wirelessly transmit data relating to the rotor parameter measurement to a base station.

According to one embodiment the electronic circuitry is configured to frequency transform the rotor parameter measurement to obtain a frequency spectrum of the rotor parameter measurement.

According to one embodiment the electronic circuitry is configured to compare the frequency spectrum with reference frequency spectra of the rotor parameter to determine whether a fault condition is present.

According to one embodiment the transmitter is configured to wirelessly transmit data concerning a presence of a fault condition.

One embodiment comprises a rectifier configured to rectify current obtained from the first and the second power supply terminals for powering the electronic circuitry with DC current.

According to a third aspect of the present disclosure there is provided a monitoring system for an electrical machine comprising the rotor measurement unit according to the second aspect presented herein, and a base station, wherein the rotor measurement unit is configured to wirelessly transmit data relating to the rotor parameter measurement to the base station, and wherein the base station is configured to process the data relating to the rotor parameter measurement.

According to a fourth aspect of the present disclosure there is provided an electrical machine comprising: an exciter stator, a stator, a rotor assembly comprising a main machine rotor having a field winding, and an exciter rotor having an exciter rotor winding, the exciter stator and the exciter rotor forming part of an AC/AC exciter, a multi-phase exciter rectifier arranged on the rotor assembly, and configured to rectify an AC current from the exciter rotor winding to feed the field winding with a DC current, wherein the multi-phase exciter rectifier has a plurality of phase legs, each phase leg being connected to a respective electrical phase of the exciter rotor winding, and a rotor measurement unit according to the second aspect of the present disclosure or a monitoring system according to the third aspect.

According to one embodiment the rotor measurement unit is mounted onto the rotor assembly and wherein the first and the second power supply terminals are connected to respective electrical phases of the exciter rotor winding or to a respective pole on a DC side of the multi-phase exciter rectifier.

According to one embodiment the exciter rotor winding is connected in a delta connection or a wye connection.

One embodiment comprises a power converter configured to feed the exciter stator with an AC current.

Generally, all terms used in the claims are to be interpreted according to their ordinary meaning in the technical field, unless explicitly defined otherwise herein. All references to "a/an/the element, apparatus, component, means, etc. are to be interpreted openly as referring to at least one instance of the element, apparatus, component, means, etc., unless explicitly stated otherwise.

### BRIEF DESCRIPTION OF THE DRAWINGS

The specific embodiments of the inventive concept will now be described, by way of example, with reference to the accompanying drawings, in which:
Fig. 1 schematically shows an example of a rotor measurement unit;
Fig. 2 schematically shows an example of an electrical machine having an AC/AC exciter;
Fig. 3 schematically shows an example of a rotor measurement unit connected to an exciter rotor winding that is delta connected; and
Fig. 4 schematically shows an example of a rotor measurement unit connected to an exciter rotor winding that is wye connected.

### DETAILED DESCRIPTION

The inventive concept will now be described more fully hereinafter with reference to the accompanying drawings, in which exemplifying embodiments are shown. The inventive concept may, however, be embodied in many different forms and should not be construed as limited to the embodiments set forth herein; rather, these embodiments are provided by way of example so that this disclosure will be thorough and complete, and will fully convey the scope of the inventive concept to those skilled in the art. Like numbers refer to like elements throughout the description.

The present disclosure relates to a rotor measurement unit configured to measure one or more rotor parameters of a rotating electrical machine having an AC/AC exciter. The rotating electrical machine may in particular be a synchronous machine such as a synchronous motor or a synchronous generator. The rotor parameters are advantageously related to the AC/AC exciter, e.g. electrical exciter parameters and/or thermal exciter rotor parameters, or to a main machine rotor. The rotor measurement unit is arranged to be assembled to or installed onto the rotor assembly, which includes the exciter rotor, the main machine rotor and the rotor shaft.

The rotor measurement unit may be specifically configured to be connected to the exciter rotor winding which is connected in a delta or wye configuration, or equivalently, to the AC side of a multi-phase exciter rectifier which is configured to rectify AC current induced in the exciter rotor winding to DC current to feed the field winding for powering the rotor measurement unit. Alternatively, the rotor measurement unit may be configured to be connected to the field winding, i.e. to the DC side of the multi-phase exciter rectifier. In this latter case, the rotor measurement unit may be configured to be connected to the two electrical poles of the field winding.

Hence, the rotor measurement unit has a first and a second power supply terminal connectable to a first electrical phase and a second electrical phase, respectively, of the exciter rotor winding, or to the plus pole and the minus pole of the field winding. Hereby, the rotor measurement unit is able to be powered both during rotation of the rotor and when the rotor is at standstill, as long as the power converter feeds the exciter stator with AC power while the rotor is at a standstill.

The rotor measurement unit is furthermore configured to measure at least one rotor parameter of the rotor by means of a measurement system. Such rotor parameters may for example be an electrical rotor parameter, for example a field winding current, a field winding voltage, or an electrical exciter parameter such as an exciter rotor winding voltage, an exciter rotor winding current, or a rotor temperature. The measurement system is configured to provide any rotor parameter measurement to electronic circuitry of the rotor measurement unit for handling the rotor parameter measurement.

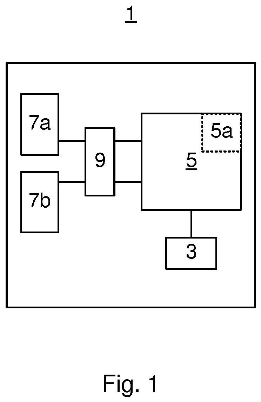

Fig. 1 shows an example of a rotor measurement unit 1. Rotor measurement unit 1 is configured to be mounted onto a rotor assembly comprising a rotor shaft, the main machine rotor having a field winding, and the exciter rotor having an exciter rotor winding. The rotor measurement unit 1 is hence arranged to be mounted to one of the rotor shaft, the main machine rotor or to the exciter rotor. To this end, the rotor measurement unit 1 has attachment means for mounting it to the rotor assembly.

The rotor measurement unit 1 comprises a measurement system 3 configured to measure a rotor parameter. The measurement system 3 may hence for example comprise one or more terminals, e.g. a first measurement terminal, for connection to e.g. the exciter rotor winding or the field winding. The measurement system 3 may also include a temperature sensor for measuring a rotor temperature.

The rotor measurement unit 1 furthermore comprises electronic circuitry 5 configured to receive rotor parameter measurements of a rotor parameter measured by the measurement system 3.

According to one variation, the electronic circuitry 5 may be configured to process the rotor parameter measurements e.g. by frequency transforming a time-domain rotor parameter measurement for example by means of a Fourier transform, and analysing the frequency spectrum by comparing it with reference frequency spectra of various faults or undesired conditions. The rotor measurement unit may in this case comprise a storage unit containing the reference frequency spectra, or it may receive the reference frequency spectra wirelessly from a base station in real-time or essentially in real-time during the process of comparing. Examples of such faults or undesired conditions are inter-turn defects in the rotor winding, problems in the damper winding or stator winding, exciter winding defects, and defects in the semiconductor accessories of the multi-phase exciter rectifier of the electrical machine. The particular fault/undesired condition analysed depends on the rotor parameter that is being measured by the measurement system 3. The signature spectra of the reference frequency spectra are not the subject of the present disclosure, and will therefore not be discussed any further herein. The electronic circuitry 5 may in this case include processing circuitry using any combination of one or more of a suitable central processing unit (CPU), multiprocessor, microcontroller, digital signal processor (DSP), application specific integrated circuit (ASIC), field programmable gate arrays (FPGA) etc., capable of executing operations relating to fault diagnostics.

According to one variation, the electronic circuitry 5 may comprise a transmitter 5a. The transmitter 5a is configured to send data relating to the rotor parameter measurements wirelessly to a base station arranged distanced from the rotor on which the rotor measurement unit 1 is installed. This data relating to the rotor parameter measurements may for example be include the rotor parameter measurements as such and/or diagnosis results in variations in which the electronic circuitry 5 is able determine faults as disclosed in the previous paragraph.

The rotor measurement unit 1 is configured to withstand the harsh conditions present in an electrical machine. The rotor measurement unit 1 may for example comprise a shielding structure for shielding electromagnetic forces present in an electrical machine during operation, from the electronic circuitry 5.

The rotor measurement unit 1 comprises a first power supply terminal 7a and a second power supply terminal 7b for powering the electronic circuitry 5 both during rotating operation of the electrical machine and under a standstill condition during which the rotor is at a standstill.

According to one variation the first power supply terminal 7a is configured to be connected to a first electrical phase of a multi-phase exciter rotor winding. The second power supply terminal is configured to be connected to a second electrical phase of the multi-phase exciter rotor winding. The exciter rotor winding is furthermore connected in one of a delta connection and a wye connection. The rotor measurement unit 1 may thereby be powered through induction both when the rotor is rotating and when the rotor or electrical machine is in a standstill as long as the exciter stator is fed with AC power from a power converter.

According to another variation, the first power supply terminal 7a is configured to be connected to a first pole of the field winding. The second power supply terminal is configured to be connected to a second pole of the field winding.

The rotor measurement unit 1 may furthermore comprise a rectifier 9 configured to rectify the alternating current provided by the first power supply terminal 7a and the second power supply terminal 7b in variations in which the rotor measurement unit 1 is designed to be connected to the exciter rotor winding, to feed the electronic circuitry 5 with DC power.

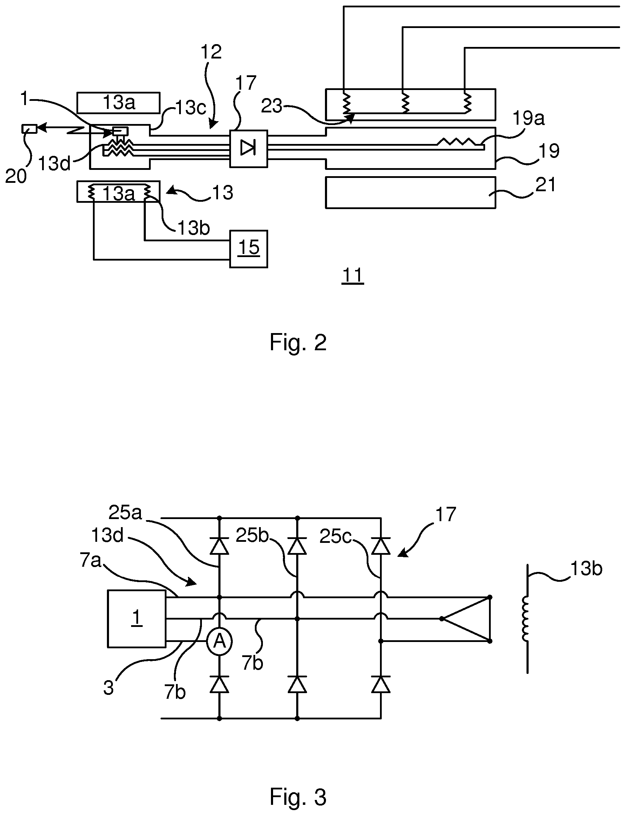

Fig. 2 shows an example of an electrical machine 11 comprising an AC/AC exciter 13 and a power converter 15, in particular a frequency converter. The AC/AC exciter 13 has an exciter stator 13a and an exciter stator winding 13b provided in the exciter stator 13a. The power converter 15 is arranged to feed the exciter stator winding 13b with AC power. As is well-known, power converter 15 can be controlled to provide power with different frequencies and magnitude. The AC/AC exciter 13 furthermore has an exciter rotor 13c which forms part of the rotor assembly 12 of the electrical machine 11, and an exciter rotor winding 13d provided on the exciter rotor 13c, and which according to the example in Fig. 2 is a multi-phase winding connected in a wye connection. The exciter rotor winding could alternatively be connected in delta, as shown in Fig. 3.

The electrical machine 11 furthermore includes a multi-phase exciter rectifier 17, a main machine rotor 19, a field winding 19a provided on the main machine rotor 19, a stator 21, and a stator winding 23 arranged in the stator 21.

The exciter rotor winding 13d is connected to the multi-phase exciter rectifier 17 which is configured to deliver DC power to the field winding 19a. The exciter rotor winding 13d is configured to electromagnetically interact with the exciter stator winding 13b.

The field winding 19a and the exciter rotor winding 13d are connected via the multi-phase exciter rectifier 17. The multi-phase exciter rectifier 17 comprises semiconducting devices such as diodes, thyristors, IGBTs or the like for converting multi-phase AC voltage to DC voltage. The multi-phase exciter rectifier 17 may be a full-wave rectifier or a half-wave rectifier.

The field winding 19a is arranged to electromagnetically interact with the stator 21 and the stator winding 23.

According to the example in Fig. 2, the rotor measurement unit 1 is mounted on the rotor assembly 12, in particular to the exciter rotor 13c. Moreover, a base station 20 is also shown, which together with the rotor measurement unit 1 forms a monitoring system of the electrical machine 11. The rotor measurement unit 1 and the base station 20 are configured to wirelessly communicate. In particular, the rotor measurement unit 1 is arranged to transmit data relating to rotor parameter measurements, and the base station 20 is arranged to process this data. The base station 20 may for example be arranged to perform diagnostics of the data relating to rotor parameter measurements, e.g. by frequency transforming the data in case the data comprises a rotor parameter measurement, and comparing the thus obtained frequency spectrum with reference frequency spectra of various faults.

Turning now to Fig. 3, an example of a connection of the rotor measurement unit 1 with the exciter rotor winding 13d is shown. In this example, the multi-phase exciter rectifier 17 is implemented by means of diodes, but as previously mentioned, other implementations are also possible.

In the case of the example in Fig. 3, the exciter rotor winding 13d has three electrical phases 25a-25c. These electrical phases 25a-25c are connected to corresponding phase legs of the AC side of the multi-phase exciter rectifier 17. Hereto, the electrical phases 25a-25c and the phase legs will be referred to interchangeably herein.

According to the present example, the exciter rotor winding 13d is connected in a delta configuration, which thereby can be seen as forming a secondary winding of a transformer, where the primary winding is the exciter stator winding 13b. Thus, when the rotor assembly 12 is in a standstill, and if the exciter stator winding 13b is fed with an AC current from the power converter 15, currents will be induced in the electrical phases or phase legs 25a-25c. The first power supply terminal 7a is connected to electrical phase or phase leg 25a and the second power supply terminal 7b is connected to electrical phase or phase leg 25b.

Moreover, according to the example, the measurement system 3 has a first measurement terminal connected to phase leg 25a, for measuring an exciter rotor winding current. It should however be noted, as has been indicated above, that it is envisaged that other rotor parameters could be measured instead of, or in addition to the exciter rotor winding current/voltage.

It should be noted in a variation of this example that the first power supply terminal 7a could instead be connected to a first pole of the field winding and the second power supply terminal 7b could instead be connected to a second pole of the field winding.

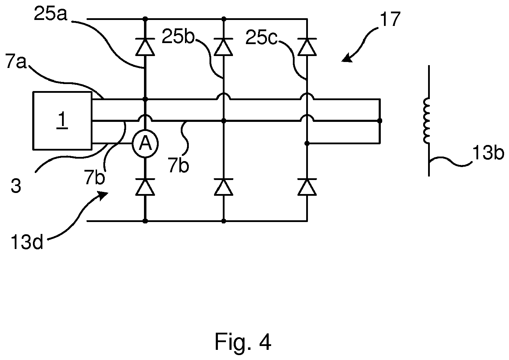

Fig. 4 shows a similar configuration as Fig. 3, except that the electrical phases 25a-25c of the exciter rotor winding 13d are connected in a wye configuration.

The inventive concept has mainly been described above with reference to a few examples. However, as is readily appreciated by a person skilled in the art, other embodiments than the ones disclosed above are equally possible within the scope of the inventive concept, as defined by the appended claims.

## Claims

1. An electrical machine (11) comprising:
an exciter stator (13a),
a stator (21) interacting with a field winding (19a),
a rotor assembly (12) comprising a main machine rotor (19) including said field winding (19a), and an exciter rotor (13c) having an exciter rotor winding (13d), the exciter stator (13a) and the exciter rotor (13c) forming part of an AC/AC exciter (13),
a multi-phase exciter rectifier (17) arranged on the rotor assembly (12), and configured to rectify an AC current from the exciter rotor winding (13d) to feed the field winding (19a) with a DC current, wherein the multi-phase exciter rectifier (17) has a plurality of phase legs (25a-25c), each phase leg (25a-25c) being connected to a respective electrical phase of the exciter rotor winding, and
a rotor measurement unit (1) mounted onto the rotor assembly (12) for measuring a rotor parameter, the rotor measurement unit (1) comprising:
a measurement system (3) configured to measure the rotor parameter,
electronic circuitry (5) configured to receive a rotor parameter measurement from the measurement system (3), and
a first and a second power supply terminal (7a, 7b) connected to respective electrical phases (25a, 25b) of the exciter rotor winding (13d) or to the field winding (19a) to enable powering of the electronic circuitry (5) during standstill operation of the electrical machine (11).

2. The electrical machine (11) as claimed in claim 1, wherein the rotor parameter is an electrical exciter parameter.

3. The electrical machine (11) as claimed in any of the preceding claims, wherein the measurement system (3) comprises a first measurement terminal configured to be connected to an AC side of a multi-phase exciter rectifier (17) of the electrical machine (11).

4. The electrical machine (11) as claimed in any of the preceding claims, wherein the measurement system (3) comprises a temperature sensor configured to measure a rotor temperature.

5. The electrical machine (11) as claimed in any of the preceding claims, wherein the electronic circuitry (5) comprises a transmitter (5a) configured to wirelessly transmit data relating to the rotor parameter measurement to a base station (20).

6. The electrical machine (11) as claimed in any of the preceding claims, wherein the electronic circuitry (5) is configured to frequency transform the rotor parameter measurement to obtain a frequency spectrum of the rotor parameter measurement.

7. The electrical machine (11) as claimed in claim 6, wherein the electronic circuitry (5) is configured to compare the frequency spectrum with reference frequency spectra of the rotor parameter to determine whether a fault condition is present.

8. The electrical machine (11) as claimed in claim 7, wherein the transmitter is configured to wirelessly transmit data concerning a presence of a fault condition.

9. The electrical machine (11) as claimed in any of the preceding claims, comprising a rectifier (9) configured to rectify current obtained from the first and the second power supply terminals (7a, 7b) for powering the electronic circuitry (5) with DC current.

10. The electrical machine (11) as claimed in any of the preceding claims, comprising a base station (20), wherein the rotor measurement unit (1) is configured to wirelessly transmit data relating to the rotor parameter measurement to the base station (20), and wherein the base station (20) is configured to process the data relating to the rotor parameter measurement.

11. The electrical machine (11) as claimed in any of the preceding claims, wherein the exciter field winding is connected in a delta connection or a wye connection.

12. The electrical machine (11) as claimed in any of the preceding claims, comprising a power converter (15) configured to feed the exciter stator (13a) with an AC current.

## Patentansprüche

1. Elektrische Maschine (11), die Folgendes umfasst:
einen Erregerstator (13a),
einen Stator (21), der mit einer Feldwicklung (19a) in Wechselwirkung tritt,
eine Rotoranordnung (12), die einen Hauptmaschinenrotor (19), der die Feldwicklung (19a) enthält, und einen Erregerrotor (13c) mit einer Erregerrotorwicklung (13d) enthält, wobei der Erregerstator (13a) und der Erregerrotor (13c) eine Komponente eines AC/AC-Erregers (13) bilden,
einen Mehrphasen-Erregergleichrichter (17), der auf der Rotoranordnung (12) angeordnet und konfiguriert ist, einen Wechselstrom von der Erregerrotorwicklung (13d) gleichzurichten, um der Feldwicklung (19a) einen Gleichstrom zuzuführen, wobei der Mehrphasen-Erregergleichrichter (17) mehrere Phasenzweige (25a-25c) aufweist, wobei jeder Phasenzweig (25a-25c) mit einer jeweiligen elektrischen Phase der Erregerrotorwicklung verbunden ist, und
eine Rotormesseinheit (1), die zum Messen eines Rotorparameters auf der Rotoranordnung (12) angebracht ist, wobei die Rotormesseinheit (1) Folgendes umfasst:
ein Messsystem (3), das konfiguriert ist, den Rotorparameter zu messen,
eine elektronische Schaltungsanordnung (5), die konfiguriert ist, eine Rotorparametermessung vom Messsystem (3) zu empfangen, und
einen ersten und einen zweiten Energieversorgungsanschluss (7a, 7b), die mit jeweiligen elektrischen Phasen (25a, 25b) der Erregerrotorwicklung (13d) oder mit der Feldwicklung (19a) verbunden sind, um das Versorgen der elektronischen Schaltungsanordnung (5) mit Energie während eines Stillstandsbetriebs der elektrischen Maschine (11) zu ermöglichen.

2. Elektrische Maschine (11) nach Anspruch 1, wobei der Rotorparameter ein elektrischer Erregerparameter ist.

3. Elektrische Maschine (11) nach einem der vorhergehenden Ansprüche, wobei das Messsystem (3) einen ersten Messanschluss umfasst, der konfiguriert ist, mit einer Wechselstromseite eines Mehrphasen-Erregergleichrichters (17) der elektrischen Maschine (11) verbunden zu sein.

4. Elektrische Maschine (11) nach einem der vorhergehenden Ansprüche, wobei das Messsystem (3) einen Temperatursensor umfasst, der konfiguriert ist, eine Rotortemperatur zu messen.

5. Elektrische Maschine (11) nach einem der vorhergehenden Ansprüche, wobei die elektronische Schaltungsanordnung (5) eine Übertragungseinrichtung (5a) umfasst, die konfiguriert ist, Daten bezüglich der Rotorparametermessung drahtlos an eine Basisstation (20) zu übertragen.

6. Elektrische Maschine (11) nach einem der vorhergehenden Ansprüche, wobei die elektronische Schaltungsanordnung (5) konfiguriert ist, die Rotorparametermessung einer Frequenztransformation zu unterziehen, um ein Frequenzspektrum der Rotorparametermessung zu erhalten.

7. Elektrische Maschine (11) nach Anspruch 6, wobei die elektronische Schaltungsanordnung (5) konfiguriert ist, das Frequenzspektrum mit Frequenzspektren des Rotorparameters zu vergleichen, um zu bestimmen, ob ein Fehlerzustand vorliegt.

8. Elektrische Maschine (11) nach Anspruch 7, wobei die Übertragungseinrichtung konfiguriert ist, Daten, die ein Vorliegen eines Fehlerzustands betreffen, drahtlos zu übertragen.

9. Elektrische Maschine (11) nach einem der vorhergehenden Ansprüche, die einen Gleichrichter (9) umfasst, der konfiguriert ist, zum Versorgen der elektronischen Schaltungsanordnung (5) mit Energie mit Gleichstrom einen Strom gleichzurichten, der vom ersten und vom zweiten Energieversorgungsanschluss (7a, 7b) erhalten wird.

10. Elektrische Maschine (11) nach einem der vorhergehenden Ansprüche, die eine Basisstation (20) umfasst, wobei die Rotormesseinheit (1) konfiguriert ist, Daten bezüglich der Rotorparametermessung drahtlos an die Basisstation (20) zu übertragen, und wobei die Basisstation (20) konfiguriert ist, die Daten bezüglich der Rotorparametermessung zu verarbeiten.

11. Elektrische Maschine (11) nach einem der vorhergehenden Ansprüche, wobei die Erregerfeldwicklung in einer Deltaverbindung oder einer Y-Verbindung angeschlossen ist.

12. Elektrische Maschine (11) nach einem der vorhergehenden Ansprüche, die einen Leistungsumrichter (15) umfasst, der konfiguriert ist, dem Erregerstator (13a) einen Wechselstrom zuzuführen.

## Revendications

1. Machine électrique (11) comportant :
un stator (13a) d'excitatrice,
un stator (21) interagissant avec un enroulement (19a) de champ,
un ensemble rotor (12) comportant un rotor principal (19) de machine comprenant ledit enroulement (19a) de champ, et un rotor (13c) d'excitatrice doté d'un enroulement (13d) de rotor d'excitatrice, le stator (13a) d'excitatrice et le rotor (13c) d'excitatrice faisant partie d'une excitatrice alternatif-alternatif (13),
un redresseur polyphasé (17) d'excitatrice disposé sur l'ensemble rotor (12), et configuré pour redresser un courant alternatif provenant de l'enroulement (13d) de rotor d'excitatrice afin d'alimenter l'enroulement (19a) de champ avec un courant continu, le redresseur polyphasé (17) d'excitatrice comprenant une pluralité de branches (25a-25c) de phases, chaque branche (25a-25c) de phase étant reliée à une phase électrique respective de l'enroulement de rotor d'excitatrice, et
une unité (1) de mesure de rotor monté sur l'ensemble rotor (12) pour mesurer un paramètre de rotor, l'unité (1) de mesure de rotor comportant :
un système (3) de mesure configuré pour mesurer le paramètre de rotor, une circuiterie électronique (5) configurée pour recevoir une mesure de paramètre de rotor en provenance du système (3) de mesure, et
une première et une seconde borne (7a, 7b) d'alimentation électrique reliées à des phases électriques respectives (25a, 25b) de l'enroulement (13d) de rotor d'excitatrice ou à l'enroulement (19a) de champ pour permettre l'alimentation de la circuiterie électronique (5) pendant un fonctionnement à l'arrêt de la machine électrique (11).

2. Machine électrique (11) selon la revendication 1, le paramètre de rotor étant un paramètre d'excitatrice électrique.

3. Machine électrique (11) selon l'une quelconque des revendications précédentes, le système (3) de mesure comportant une première borne de mesure configurée pour être reliée à un côté courant alternatif d'un redresseur polyphasé (17) d'excitatrice de la machine électrique (11).

4. Machine électrique (11) selon l'une quelconque des revendications précédentes, le système (3) de mesure comportant un capteur de température configuré pour mesurer une température de rotor.

5. Machine électrique (11) selon l'une quelconque des revendications précédentes, la circuiterie électronique (5) comportant un transmetteur (5a) configuré pour transmettre sans fil des données se rapportant à la mesure de paramètre de rotor à une station (20) de base.

6. Machine électrique (11) selon l'une quelconque des revendications précédentes, la circuiterie électronique (5) étant configurée pour appliquer une transformation en fréquence à la mesure de paramètre de rotor afin d'obtenir un spectre de fréquences de la mesure de paramètre de rotor.

7. Machine électrique (11) selon la revendication 6, la circuiterie électronique (5) étant configurée pour comparer le spectre de fréquences à des spectres de fréquences de référence du paramètre de rotor afin de déterminer si un état de défaillance est présent.

8. Machine électrique (11) selon la revendication 7, l'émetteur étant configuré pour transmettre sans fil des données concernant la présence d'un état de défaillance.

9. Machine électrique (11) selon l'une quelconque des revendications précédentes, comportant un redresseur (9) configuré pour redresser un courant obtenu en provenance des première et seconde bornes (7a, 7b) d'alimentation électrique afin d'alimenter la circuiterie électronique (5) en courant continu.

10. Machine électrique (11) selon l'une quelconque des revendications précédentes, comportant une station (20) de base, l'unité (1) de mesure de rotor étant configurée pour transmettre sans fil à la station (20) de base des données se rapportant à la mesure de paramètre de rotor, et la station (20) de base étant configurée pour traiter les données se rapportant à la mesure de paramètre de rotor.

11. Machine électrique (11) selon l'une quelconque des revendications précédentes, l'enroulement de champ d'excitatrice étant raccordé suivant une connexion en triangle ou une connexion en étoile.

12. Machine électrique (11) selon l'une quelconque des revendications précédentes, comportant un convertisseur (15) de puissance configuré pour alimenter le stator (13a) d'excitatrice avec un courant alternatif.
